Europäisches Patentamt

European Patent Office

Office européen des brevets

(19)

(11) EP 0 507 499 B1

## (12) EUROPEAN PATENT SPECIFICATION

(45) Date of publication and mention
of the grant of the patent:
**20.05.1998 Bulletin 1998/21**

(51) Int Cl.6: **H04B 1/66**

(21) Application number: **92302617.3**

(22) Date of filing: **26.03.1992**

(54) **Orthogonal transform coding apparatus for digital audio signals**

Einrichtung zur Orthogonaltransformationskodierung eines digitalen Audiosignals

Dispositif de codage par transformée orthogonale pour signaux audio numériques

(84) Designated Contracting States:
**AT DE FR GB IT NL**

(30) Priority: **30.03.1991 JP 92738/91**

(43) Date of publication of application:
**07.10.1992 Bulletin 1992/41**

(73) Proprietor: **SONY CORPORATION
Tokyo 141 (JP)**

(72) Inventor: **Oikawa, Yoshiaki
Shinagawa-ku Tokyo 141 (JP)**

(74) Representative: **Thomas, Christopher Hugo et al
D. Young & Co,
21 New Fetter Lane
London EC4A 1DA (GB)**

(56) References cited:
**EP-A- 0 064 119          EP-A- 0 386 418**

## Description

This invention relates to coding apparatus for digital signals.

One way of achieving bit compression when encoding, for example, an audio signal, uses the so-called block floating method in which input data are divided into data blocks every predetermined number of words, and floating processing is effected on each block. In this method the maximum absolute value of the words in each block is found, and floating processing is effected using this maximum absolute value as a common floating coefficient for all the words in that block.

Another known method uses so-called orthogonal transform coding to transform a signal on the time base to a signal on the frequency base for encoding. Such orthogonal transform coding may comprise fast fourier transform (FFT) or discrete cosine transform (DCT) processing of audio PCM data every fixed number of words (number of samples) in the time base direction.

There has also been proposed a coding apparatus for a digital signal, in which the above methods are combined thereby to divide a signal on the frequency base into signal components in blocks of predetermined frequency band, for example, the so-called critical band and carry out floating processing on each block.

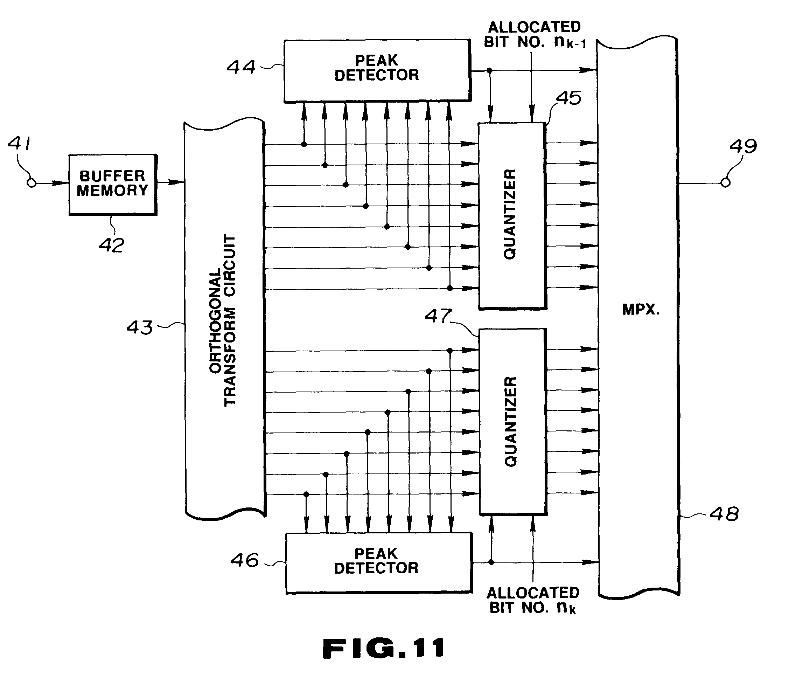

Figure 11 shows the configuration of part of a coding apparatus for a digital signal, in which orthogonal transform and block floating processing are combined.

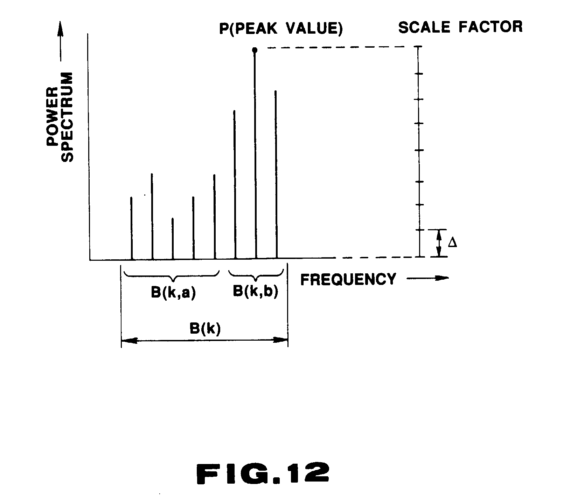

In Figure 11, a digital signal, such as an audio PCM signal, supplied to an input terminal 41 is temporarily stored in a buffer memory 42, and is then orthogonally transformed, for example, by a circuit 43 for orthogonal transform, such as FFT. In Figure 11, there is shown the part of the circuit for the (K-1)-th and K-th critical bands where, for example, the number of spectrum components (FFT coefficients) are both eight. Thus data of eight spectrum components of the (K-1)-th band (block) are supplied to a peak detector 44 and a quantizer 45. These date are quantized by a scale factor corresponding to a peak value detected by the peak detector 44. Data of eight spectrum components of the K-th band (block) are supplied to a peak detector 46 and a quantizer 47. An example of data of eight spectrum components is shown in Figure 12.

At these quantizers 45 and 47, spectrum data of respective bands are quantized by a scale factor based on respective peak values obtained from the respective peak detectors 44 and 46, and allocated bit numbers $n_{k-1}$ and $n_k$ of respective bands obtained by other processing. The quantized spectrum signals are supplied to a multiplexer 48, and are combined with spectrum signals of other bands or auxiliary information such as the allocated bit number. The signal thus combined is derived from an output terminal 49.

Meanwhile, in the case where a signal in one critical band has any deviation, that is, in the case of a signal in which the so-called tonality is high is inputted, as shown for example in Figure 12, there would occur within the block B(k) a portion B(K,b) at which a signal allowing the tonality to be high is dominant and a portion B(k,a) at which such a signal is not dominant. In this case, if the floating processing is carried out by using the peak value P in the block B(k) as a scale factor, the portion B(k,b) at which a signal allowing the tonality to be high is dominant is no problem, but there would occur degradation with respect to the portion B(k,a) at which such a signal is not dominant. In Figure 12, the example where the allocated bit number $n_k$ is three is shown. It is seen that when a signal is quantized with a step size $\Delta$ in this case, the quantization step size $\Delta$ is relatively large with respect to a signal of the portion B(k,a) at which a tonality signal is not dominant. If quantization is carried out with a quantization step which is relatively large with respect to a signal as stated above, the quantization noise becomes large, resulting in the drawback that noise might be heard after carrying out synthesis at a decoder for reproduction of the signal.

European Published Patent Application EP-A-0,064,119 discloses a speech coding technique in which the speech signal is split into bands that are quantized to differing scale factors.

According to the present invention there is provided a coding apparatus for a digital signal which divides an input digital signal into signal components in a plurality of bands of predetermined frequencies to carry out orthogonal transform on each divided band, signal components on the frequency base being divided into blocks in critical bands then to carry out floating processing thereof; wherein said critical bands are further divided into small blocks to compare respective indices for the floating processing for each small block to carry out the floating processing when the compared difference is above a fixed value.

In embodiments of the invention, as a digital signal on the frequency base, spectrum data obtained by orthogonally transforming, for example, a digital signal on the time base by FFT or DCT, may be used. As the predetermined frequency band, the so-called critical band may be used. In addition, as the index of the floating processing for every small block, a maximum absolute value (peak value) in the small block may be used.

When a signal having high tonality is inputted, a difference between indices (maximum absolute values, etc.) of the floating processing for every small block appears as a large value and exceeds the above-mentioned fixed value. Accordingly, at this time, if floating processing is carried out on every small block, the portion where a signal having high tonality is not dominant is also quantized by a suitable scale factor. Thus, quantization noise can be reduced.

The invention will now be described by way of example with reference to the accompanying drawings, throughout which like parts are referred to by like references, and in which:

Figure 1 is a block circuit diagram of part of an embodiment of coding apparatus according to the present invention;

Figure 2 is a frequency spectrum diagram for explaining the operation of the embodiment;

Figure 3 is a frequency spectrum diagram for explaining another operation of the embodiment;

Figure 4 is a frequency spectrum diagram for explaining the operation of another embodiment;

Figure 5 is a block circuit diagram of coding apparatus for a digital signal to which the embodiment can be applied;

Figure 6 shows division of the frequency band into blocks in a time base direction in the apparatus of Figure 5;

Figure 7 is a block circuit diagram of an allowed noise detector of the apparatus of Figure 5;

Figure 8 shows a bark spectrum;

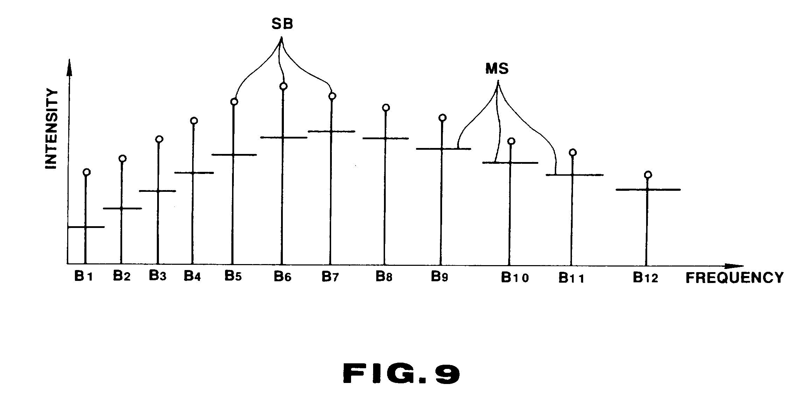

Figure 9 shows a masking spectrum;

Figure 10 shows a minimum audible curve and the masking spectrum synthesized;

Figure 11 is a block circuit diagram of part of a previously proposed apparatus; and

Figure 12 is a frequency spectrum diagram for explaining the operation of the apparatus of Figure 11.

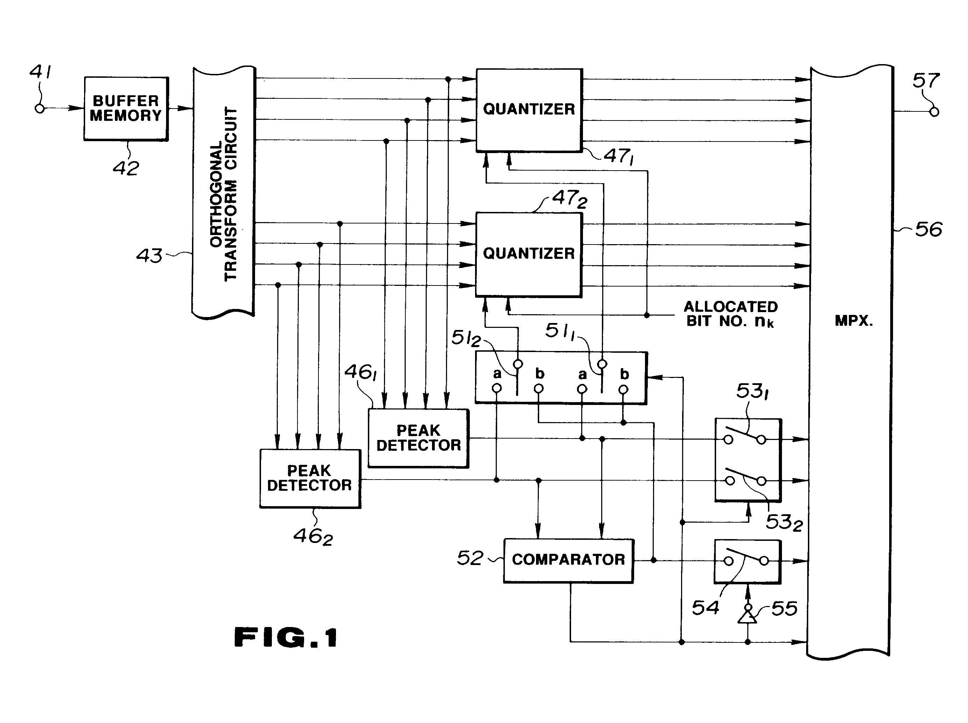

In the embodiment of Figure 1, a digital signal such as an audio PCM signal, is supplied to an input terminal 41. This digital signal is temporarily stored in a buffer memory 42, at which it undergoes orthogonal transform (FFT) processing. In Figure 1, there is shown the part of the circuit corresponding to the K-th critical band (block of the floating processing unit) where, for example, the number of spectrum components (FFT coefficients) is eight. Data of eight spectrum components of the K-th band (block) are halved into small blocks respectively having four spectrum components.

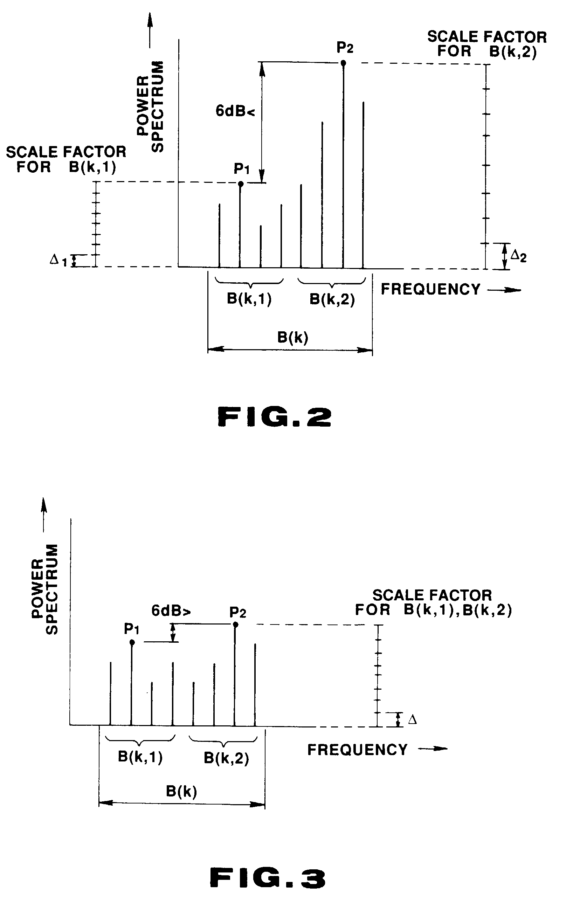

Thus, in Figure 2, a block $B(k)$ corresponding to the K-th critical band is divided into two small blocks $B(k,1)$ and $B(k,2)$. Data of four spectrum components of one divided small block $B(k,1)$ are supplied to a peak detector $46_1$ and a quantizer $47_1$, and data of four spectrum components of the other small block $B(k,2)$ are supplied to a peak detector $46_2$ and a quantizer $47_2$. The peak detectors $46_1$ and $46_2$ respectively detect peak values (maximum absolute values) $P_1$ and $P_2$ of the small blocks $B(k,1)$ and $B(k,2)$ to output these values as respective scale factors. A scale factor (peak value) from the peak detector $46_1$ is supplied to a selected terminal a of a changeover switch $51_1$ and a comparator 52, and is supplied to a multiplexer 56 through a switch $53_1$. A scale factor from the peak detector $46_2$ is supplied to a selected terminal a of a changeover switch $51_2$ and the comparator 52, and is also supplied to the multiplexer 56 through a switch $53_2$.

The comparator 52 outputs the greater one of respective scale factors (larger one of peak values) from the respective peak detectors $46_1$ and $46_2$, and judges

the tonality. The judgement of tonality is carried out in dependence upon whether or not there is a difference between peak values (maximum absolute values) $P_1$ and $P_2$ of respective small blocks $B(k,1)$ and $B(k,2)$. A greater scale factor (peak value) from the comparator 52 is supplied to the multiplexer 56 through a switch 54. A judged result of tonality from the comparator 52 is supplied as a control signal to each of the changeover switches $51_1$ and $51_2$, and the switches $53_1$ and $53_2$. The above-mentioned judged result from the comparator 52 is also supplied as a control signal to the switch 54 through an inverter 55.

The quantizer $47_1$ commonly quantizes data of four spectrum components in the small block $B(k,1)$ (block floating quantization) by a scale factor (peak value) from the changeover switch $51_1$ and an allocated bit number $n_k$ determined by other processing. The quantizer $47_2$ commonly quantizes data of four spectrum components in the small block $B(k,2)$ by a scale factor from the changeover switch $51_2$ and the allocated bit number $n_k$. The spectrum signals quantized by the quantizers $47_1$ and $47_2$ are both supplied to the multiplexer 56. The multiplexer 56 combines the quantized spectrum signals or the scale factor information to output a signal indicative of the combined result from the output terminal 57.

In such a configuration, the following operation is carried out in accordance with the tonality of an input signal.

In the case where as the result of the fact that an input signal of high tonality is supplied or for some other reason, a difference between respective peak values (maximum absolute values ) $P_1$ and $P_2$ of small blocks $B(k,1)$ and $B(k,2)$ in a block $B(k)$ corresponding to the K-th critical band is more than 6 dB as shown in Figure 2, the comparator 52 outputs a larger peak value $P_2$ to supply it to respective selected terminals b of the changeover switches $51_1$ and $51_2$ and the switch 54. Also, at this time, in dependence upon a tonality judged result from the comparator 52, the changeover switches $51_1$ and $51_2$ are controlled so that their switch terminals are connected to the respective selected terminal a sides; the switches $53_1$ and $53_2$ are controlled so that they are turned ON; and the switch 54 is controlled so that it is turned OFF.

Accordingly, since the peak value $P_1$ from the peak detector $46_1$ is supplied as a scale factor from the changeover switch $51_1$ to the quantizer $47_1$, when it is assumed that the number of bits allocated to the K-th critical band is three, data of four spectrum components of the small block $B(k,1)$ are quantized at a quantization step size $\Delta_1$ of Figure 2. This step size $\Delta_1$ is provided by dividing the peak value $P_1$ by $2^3$ (=8) corresponding to allocated bit number $n_k=3$. Further, the peak value $P_2$ from the peak detector $46_2$ is supplied as a scale factor from the changeover switch $51_2$ to the quantizer $47_2$, data of four spectrum components of the small block $B(k,2)$ are quantized at a quantization step size $\Delta_2$ of Figure 2. Respective quantized outputs from the quantizers

$47_1$ and $47_2$ are respective peak values $P_1$ and $P_2$ from the switches $53_1$ and $53_2$ are all supplied to the multiplexer 56.

On the contrary, in the case where the tonality of an input signal is low, or in the case where the portion at which the tonality is high belongs to other critical bands, a difference between peak values $P_1$ and $P_2$ of the respective small blocks $B(k,1)$ and $B(k,2)$ is less than 6 dB, as shown in Figure 3, for example. In such a case, the comparator 52 outputs a greater peak value $P_2$ to supply it to respective selected terminals b of the changeover switches $51_1$ and $51_2$ and the switch 54. In dependence upon the tonality judged result at this time, the changeover switches $51_1$ and $51_2$ are controlled so that their switch terminals are switched to the respective selected terminal b side; the switches $53_1$ and $53_2$ are controlled so that they are turned OFF; and the switch 54 is controlled so that it is turned ON.

At this time, the peak value P2 from the comparator 52 is supplied as a scale factor to respective quantizers $47_1$ and $47_2$ through changeover switches $51_1$ and $51_2$, and spectrum data of respective small blocks $B(k,1)$ and $B(k,2)$ are quantized at a common quantization step size $\Delta$ shown in Figure 3. Thus, such data undergo the block floating processing every block $B(k)$ corresponding to the critical band, and are supplied to the multiplexer 56. In addition, the peak value $P_2$ from the comparator 52 is supplied to the multiplexer 56 through the switch 54.

As explained above, in the case where the tonality is high and a difference between respective peak values $P_1$ and $P_2$ of respective small blocks $B(k,1)$ and $B(k,2)$ is more than 6 dB, block floating processing is individually carried out on every small block $B(k,1)$ and $B(k,2)$, respectively. Thus, it is seen that spectrum data of the small block $B(k,1)$ is quantized by a suitable scale factor and a step size without being affected by the peak value $P_2$ of the small block $B(k,2)$. On the other hand, in the case where the tonality is low and a difference between respective peak values $P_1$ and $P_2$ is less than 6 dB, a greater peak value $P_2$ is taken as a peak value (maximum absolute value in the block) of the original block $B(k)$. By carrying out the block floating processing every block $B(k)$, a required result can be provided by using a single peak value.

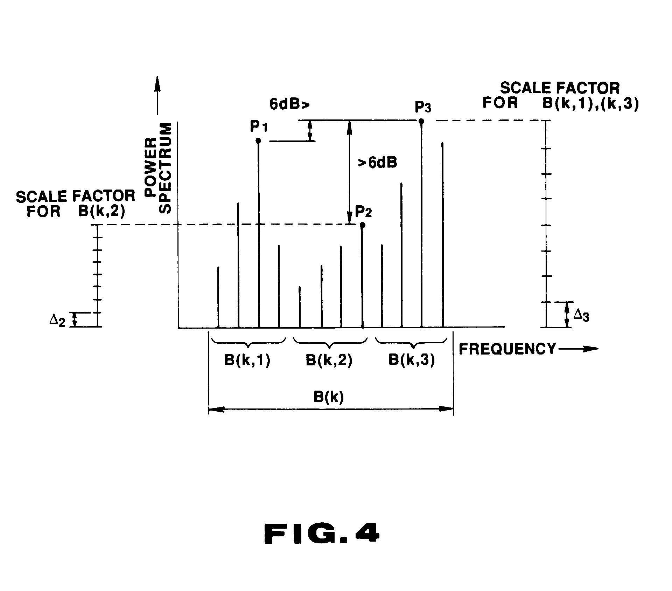

An example of the case where a block $B(k)$ corresponding to a single critical band is divided into three small blocks $B(k,1)$, $B(k,2)$ and $B(k,3)$ is shown in Figure 4. In the example of Figure 4, a maximum one of the peak values $P_1$, $P_2$ and $P_3$ of respective small blocks $B(k,1)$, $B(k,2)$ and $B(k,3)$ is taken as a peak value $P_3$. The peak value $P_1$ is assumed to have a difference less than 6 dB between the peak value $P_1$ and the peak value $P_3$, and the peak value $P_2$ is assumed to have a difference more than 6 dB between the peak value $P_1$ and the peak value $P_3$.

In the example shown in Figure 4, respective spectrum data of small blocks $B(k,1)$ and $B(k,3)$ where the difference between respective peak values is less than 6 dB are quantized by a step size $\Delta_3$ by using a greater peak value $P_3$ as a common scale factor. On the contrary, spectrum data in the small block $B(k,2)$ is quantized by a step size $\Delta_2$ by using the peak value $P_2$ as a scale factor. Thus, small blocks $B(k,1)$ and $B(k,3)$ are combined into a single block to carry out the floating processing on every single block. Further, the floating processing is carried out by using the small block $B(k,2)$ as a single block.

As stated above, when a single critical band is divided into three blocks or more, the approach employed is to determine the maximum one of peak values of these small blocks to allow small blocks where a difference between respective peak values is less than 6 dB to be a common block to carry out the block floating processing thereby to reduce the number of peak values, and independently to process small blocks where that difference is more than 6 dB thereby to prevent quantization noise from increasing.

As an actual example of a coding apparatus for a digital signal, an embodiment of this invention will be described in connection with a coding apparatus using band divisional coding (SBC), adaptive transform coding (ATC) and adaptive bit allocation (APC-AB).

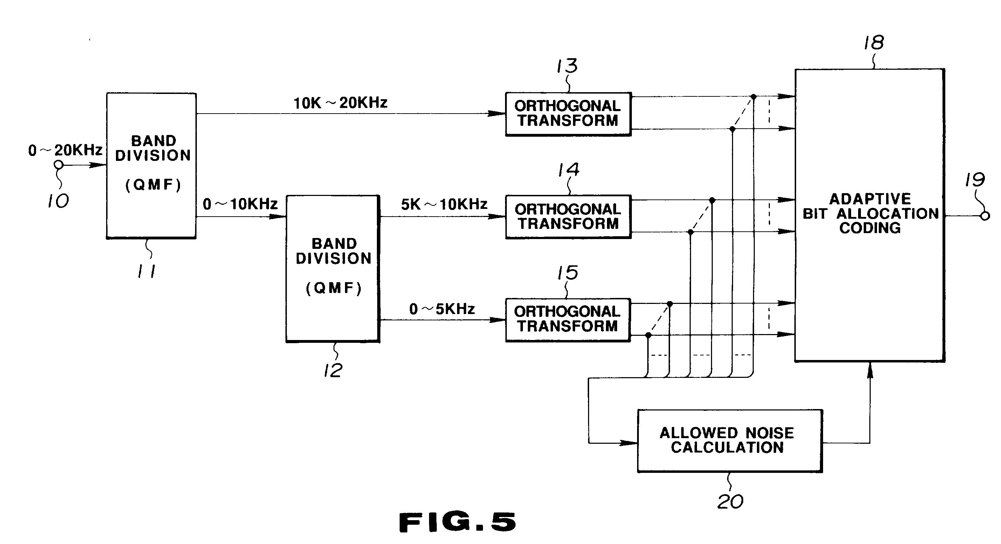

In the coding apparatus shown in Figure 5, an input digital signal is divided into signal components in a plurality of frequency bands with the bandwidth becoming broader at higher frequencies, to carry out orthogonal transform processing on respective frequency bands adaptively to bit-allocate spectrum data on the frequency base thus obtained for every so-called critical band in which human hearing characteristics, which will be described later, are taken into consideration, to encode the data. Further, in this embodiment another scheme is also employed adaptively to vary the block size (block length) in dependence upon an input signal prior to orthogonal transform processing, and to carry out floating processing on every block.

Thus, in Figure 5, an audio PCM signal, for example, of 0 to 20 KHz is supplied to the input terminal 10. This input signal is divided into signal components in the frequency band of 0 to 10 KHz and the frequency band of 10 to 20 KHz by a band division filter 11, such as a so-called QMF filter. Further, the signal component in the frequency band of 0 to 10 KHz is divided into signal components in the frequency band of 0 to 5 KHz and the frequency band of 5 to 10 KHz by a similar band division filter 12 such as a QMF filter. The signal component in the frequency band of 10 to 20 KHz from the band division filter 11 is supplied to an orthogonal transform circuit 13; the signal component in the frequency band of 5 to 10 KHz from the band division filter 12 is supplied to the FFT circuit 14; and the signal component in the frequency band of 0 to 5 KHz is supplied to the FFT circuit 15, whereby those signal components are subjected to orthogonal transform processing.

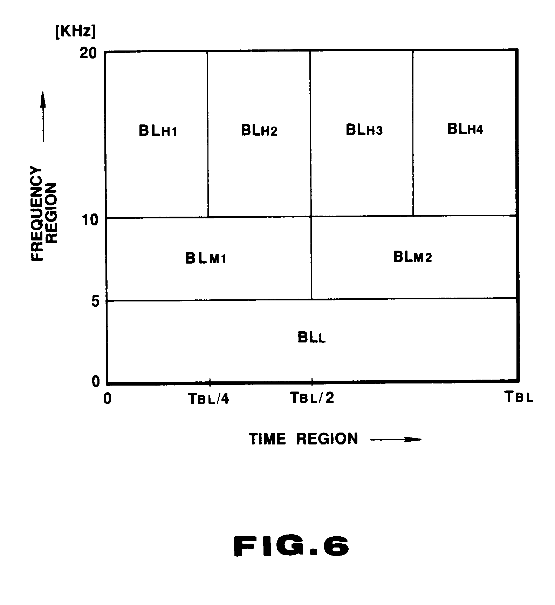

An actual example of a standard input signal with respect to blocks of respective bands, which is supplied to the respective orthogonal transform circuits 13, 14 and 15 is shown in Figure 6. In the example of Figure 6, a scheme is employed such that as the frequency increases, the frequency band becomes broader, and the time resolution becomes higher (the block length becomes short). Thus, a signal in the frequency band of 0 to 5 KHz on a lower frequency band side is assumed to be represented by one block $BL_1$ comprising, for example, 1024 samples; a signal in the medium frequency band of 5 to 10 KHz is divided into signal components in blocks $BL_{M1}$ and $BL_{M2}$ each having a block length $T_{BL/2}$ one half of that of the block $BL_L$; and a signal in the frequency band of 10 to 20 KHz is divided into blocks $BL_{H1}$, $BL_{H2}$, $BL_{H3}$ and $BL_{H4}$ each having a block length $T_{BL/4}$ one fourth of the block $BL_L$. It is to be noted in the case where the frequency band of the input signal 0 to 22 KHz, the lower frequency band is in a range of 0 to 5.5 KHz, the medium frequency band is in a range of 5.5 to 11 KHz, and the higher frequency band is in a range of 11 to 22 KHz.

Turning back to Figure 5, spectrum data on the frequency base or orthogonal transform coefficient data provided as a result of orthogonal transform processing at respective orthogonal transform circuits 13, 14 and 15, are combined every so-called critical band, and are then supplied to an adaptive bit allocation encoder 18. This critical band is frequency band divided in dependence on human hearing wherein narrow band noise having the same intensity as that of a pure sound and existing in the vicinity of the pure sound masks the pure sound. These critical bands are such that as the frequency shifts to a higher frequency, the bandwidth becomes broader, and the entire frequency band of 0 to 20 KHz is divided into 25 critical bands.

An allowed noise calculation circuit 20 determines, on the basis of spectrum data divided into critical bands, allowed noise quantities for each critical band in which the so-called masking effect, etc. is taken into consideration to determine, for each critical band, allocated bit numbers, on the basis of the allowed noise quantities and energies or peak values, etc. to requantize respective spectrum data (or orthogonal transform data) in dependence upon the number of bits allocated to respective critical bands by the adaptive bit allocation encoder 18. Data thus coded are derived at an output terminal 19.

In coding in the adaptive bit allocation encoder 18, block floating processing is carried out on every critical band. Further, as explained above, a single critical band is divided into several small blocks to carry out block floating processing on every small block in dependence upon the tonality of an input signal, that is, when the difference between respective peak values of respective small blocks is more than 6 dB. Thus, quantization noise is avoided.

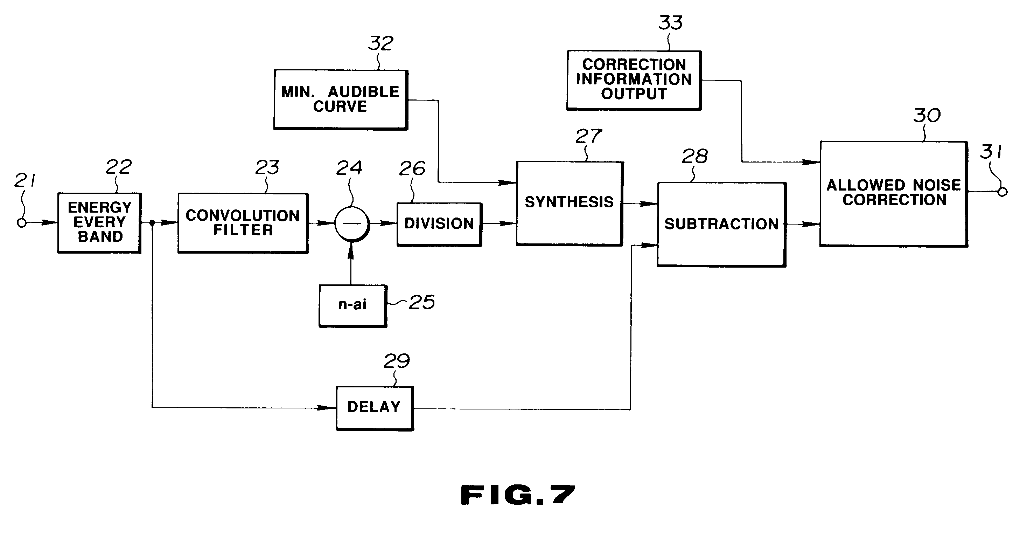

Figure 7 is a block circuit diagram of an actual example of the noise calculation circuit 20. In Figure 7, spectrum data on the frequency base from the respective orthogonal transform circuits 13, 14 and 15 are supplied to the input terminal 21. As these data, only the amplitude value and the phase value calculated on the basis of the real number component and the imaginary number component of orthogonal transform coefficient data obtained by performing the orthogonal transform operation are used. This is because human hearing is more sensitive to the amplitude (level, intensity) on the frequency base, but considerably more sensitive to the phase.

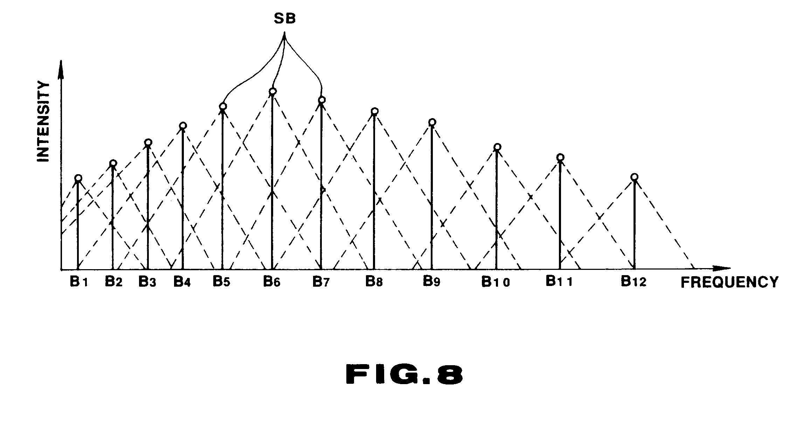

The input data on the frequency base is supplied to an energy calculation circuit 22, at which energies of each critical band are determined, for example, by calculating a sum total of respective amplitude values in the band. In place of energies of each respective band, peak values or mean values of amplitude value may be used. A spectrum of sum total of respective bands as an output from the energy calculation circuit 22 is generally called a bark spectrum. Figure 8 shows such a bark spectrum SB for respective bands. It is to be noted that, in order to simplify Figure 8, only twelve critical bands are shown ($B_1$ to $B_{12}$).

To allow for the influence in the so-called masking of the bark spectrum SB, convolution processing is used to multiply respective values of the back spectrum SB by a predetermined weighting function to add the multiplied values. To realize this, an output from a circuit 22 for calculating an energy every band, that is, respective values of the bark spectrum SB are supplied to a convolution filter circuit 23. This convolution filter circuit 23 comprises, for example, a plurality of delay elements for sequentially delaying input data, a plurality of multipliers (for example, 25 multipliers corresponding to respective bands) for multiplying outputs from these delay elements by filter coefficients (weighting function), and a sum total adder for taking a sum total of respective multiplier outputs. By this convolution processing, the sum total of the portion indicated by dotted lines in Figure 8 is derived. It is to be noted that the above-mentioned masking refers to the phenomenon that a signal is masked by another signal, and is not heard. As the masking effect, there are the simultaneous masking effect by a signal on the time base and the masking effect for an audio signal on the frequency base. Thus, due to masking effect, even if there is any noise at the portion subject to masking, such a noise will not be heard. For this reason, in an actual audio signal, noise in the portion subject to masking is considered as an allowable noise.

Referring to an example of multiplying coefficients (filter coefficients) of respective multipliers of the convolution filter circuit 23, when the coefficient of a multiplier M corresponding to an arbitrary band is assumed to be one, at the multiplier M-1, the filter coefficient 0.15 is multiplied by outputs of respective delay elements; at the multiplier M-2 the filter coefficient 0.0019 is multiplied by those outputs; at the multiplier M-3, the filter coefficient 0.0000086 is multiplied by those outputs; at the multiplier M+1, the filter coefficient 0.4 is multiplied by those outputs; at the multiplier M+2, the filter coefficient 0.06 is multiplied by those outputs; and at the multiplier M+3, the filter coefficient 0.007 is multiplied by those outputs. Thus, convolution processing of the bark spectrum SB is carried out. It is to be noted that M is an arbitrary integer of one to 25.

Thereafter, an output of the convolution filter circuit 23 is supplied to a subtracter 24 which serves to determine a level $\alpha$ corresponding to an allowable noise level, which will be described later, in the convoluted region. It is to be noted that the level $\alpha$ corresponding to the allowable noise level (allowed noise level) is a level to correspond with the allowed noise level in every band of the critical band when carrying out deconvolution processing as described later. Here, an allowed function (function representing the masking level) for determining the level $\alpha$ is supplied to the subtracter 24. By increasing or decreasing this allowed function, control of the level $\alpha$ is carried out. This allowed function is supplied from a (n-ai) function generator 25 which will be described later.

When the number given in order from a lower frequency band of bands of the critical band is assumed to be i, the level of $\alpha$ corresponding to the allowed noise level is determined by the following equation:

$$\alpha = S - (n\text{-}ai) \qquad (1)$$

where n and a are respective constants (a>0), and S is the intensity of a convolution processed bark spectrum. In the above equation (1), (n-ai) represents an allowed function. In this embodiment, n is set to 38 and a is set to 1. There then results no degradation of sound quality, and satisfactory coding is thus carried out.

In this way, the level $\alpha$ is determined. These data are transmitted to a divider 26 which serves to apply deconvolution to the level $\alpha$ in the convolution region. Accordingly, by carrying out this deconvolution, a masking spectrum is provided from the level $\alpha$. Namely, this masking spectrum becomes an allowed noise spectrum. It is to be noted that while the above-mentioned deconvolution processing requires a complicated operation, a simplified divider 26 is used in this embodiment to carry out deconvolution.

Then, the above-mentioned masking spectrum is transmitted to a subtracter 28 through a synthesis circuit 27. Here, the subtracter 28 through a synthesis circuit 27. Here, the subtracter 28 through a synthesis circuit 27. Here, the subtracter 28 is supplied with an output of the energy detector 22 in every band, that is, the previously described bark spectrum SB through a delay circuit 29. Accordingly, at this subtracter 28, a subtractive operation between the masking spectrum and the bark spectrum SB is carried out. Thus, as shown in Figure 12, the portion of the bark spectrum SB of which level is lower than the level indicated by the level of the masking spectrum MS is subjected to masking.

An output from the subtracter 28 is taken out through an allowed noise corrector 30 and the output terminal 31, and is supplied to a ROM, etc. (not shown) at which, for example, allocated bit number information are stored. This ROM, etc. serves to supply allocated bit number information every band in dependence upon an output (difference level between energy of each band and an output of the noise level setting means) obtained through the allowed noise corrector 30 from the subtracter 28. This allocated bit number information is supplied to the adaptive bit allocation encoder 18, whereby spectrum data on the frequency base from the DCT circuits 13, 14 and 15 are quantized by bit numbers allocated to respective bands.

In short, the adaptive bit allocation encoder 18 serves to quantize spectrum data in respective bands by bit numbers allocated in dependence upon levels of differences between energies of respective bands of the critical band and an output of the noise level setting means. It is to be noted that a delay circuit 29 is provided in order to delay the bark spectrum SB from the energy detector 22 by taking into consideration delay quantities at respective circuits preceding the synthesis circuit 27.

Meanwhile, in synthesis at the above-described synthesis circuit 27, it is possible to synthesize data indicating the so-called minimum audible curve RC which is the human hearing characteristic as shown in Figure 13 supplied from a minimum audible curve generator 32 and the above-mentioned masking spectrum MS. In this minimum audible curve, if the noise absolute level is below the minimum audible curve, this noise cannot be heard. Furthermore, even if coding is the same, the minimum audible curve would vary, for example, in dependence upon variation of a reproducing volume at the time of reproduction. However, it is to be noted that, since there is not so great a variation in the manner in which music enters, for example, a 16-bit dynamic range in actual digital systems, if it is assumed that quantization noise of, for example, the frequency band most easily heard in the vicinity of 4 KHz, quantization noise less than the level of the minimum audible curve is considered to be not heard in other frequency bands. Accordingly, noise in the vicinity of 4 KHz of a word length that the system has is not heard, and an allowed noise level is provided by synthesizing the minimum audible curve RC and the masking spectrum MS, the allowed noise level in this case is permitted to be the level up to the portion indicated by hatching in Figure 13. It is to be noted that, in this embodiment, the level of 4 KHz of the minimum audible curve is caused to correspond with the minimum level correspond to, for example, 20 bits. In Figure 13, signal spectrum SS is also shown.

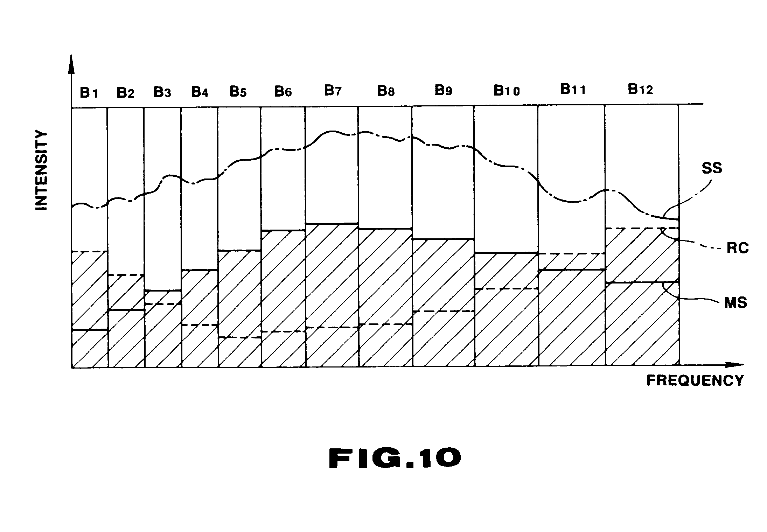

At the allowed noise level corrector 30, the allowed noise level in an output from the subtracter 28 is corrected on the basis of a so-called equi-loudness curve supplied from a correction information output circuit 33. The equi-loudness curve is related to the human hearing characteristics. This curve is obtained by determining sound pressures of sound at respective frequencies, which can be heard at the same intensity as that of a pure sound of, for example, 1 KHz. This curve is also called an equi-sensitivity curve of loudness. The equi-loudness curve is substantially the same as the minimum audible curve RC shown in Figure 10. In this equi-loudness curve, for example in the vicinity of 4 KHz, sound is heard at the same intensity as a sound at 1 KHz. In contrast, in the vicinity of 50 KHz, if the sound pressure is not higher than the sound pressure in the vicinity of 1 KHz by about 15 dB, the sound is not heard at the same intensity. For this reason, it is seen that it is desirable to allow noise above the level of the minimum audible curve (allowed noise level) to have a frequency characteristic given by a curve corresponding to the equi-1∩ness curve. For this reason, it is seen that there is adaption for human hearing characteristics, to correct the allowed noise level by taking the equi-loudness curve into consideration.

Here, as the correction information output circuit 33, there may be employed a circuit to correct the allowed noise level on the basis of a detected output of output information (data quantity) quantized at the encoder 18, and a bit rate target value of the final coded data. The reason why such a correction is made is as follows. Since there are instances where the total bit number provided by carrying out in advance a temporary adaptive bit allocation with respect to all bit allocation unit blocks may have an error with respect to a fixed number of bits (target value) determined by the bit rate of the final coded output data, it is required to carry out bit allocation for a second time, so that the above error becomes equal to zero. When the total number of allocated bits is less than the target value, bit numbers of differences are allocated to respective unit blocks to increase that number. In contrast, when the total number of allocated bits is greater than the target value, bit numbers of differences are allocated to respective unit blocks to decrease that number.

To carry this out, the correction information output circuit 33 outputs correction data for correcting respective allocated bit numbers in dependence upon detected data indicative of an error from the target value of the total number of allocated bits. Here, in the case where the error data indicates that the number of bits is insufficient, an increased number of bits per unit block is used, in consideration of the case where the data quantity is greater than the target value. Further, in the case where the error data are data indicating bit number remainder, it is sufficient that the number of bits per unit block is small, in consideration of the case where the data quantity is less than the target value. Accordingly, data of the correction value for correcting an allowed noise level in an output level from the subtracter 28 on the basis of, for example, information data of the equi-loudness curve are outputted from the correction information output circuit 33 in accordance with this error data. The correction value as described above is transmitted to the allowed noise corrector 30, whereby an allowed noise level from the subtracter 28 is corrected.

It is to be noted that this invention is not limited to the above-described embodiment, and is applicable, for example, not only to a signal processor for an audio PCM signal, but also to a signal processor for a digital speech signal or a digital video signal, etc. Further, there may be employed a configuration such that the above-described synthesis processing of the minimum audible curve is not carried out. In this case, the minimum audible curve generator 32 and the synthesis circuit 27 are unnecessary, and an output from the subtracter 24 is subjected to deconvolution at the subtracter 26, and is then transmitted directly to the subtracter 28.

## Claims

1.  A coding apparatus for a digital signal, said coding apparatus comprising:

    a divider (11,12) for dividing an input digital signal into signal components in a plurality of bands of predetermined frequencies;
    an orthogonal transform circuit (13,14,15) carrying out an orthogonal transform on each divided band, signal components on the frequency base being divided into blocks in critical bands and;
    a floating processor ($47_1,47_2$;18) carrying out floating processing of said blocks characterised by:
    means for further dividing said blocks of said critical bands into small blocks; and
    means ($46_1,46_2,52$;20) for determining and comparing respective indices for the floating processing for each small block and controlling said floating processor such that:

    (i) when the compared difference is above a fixed value, said floating processing is carried out using different indices for different small blocks within a critical band; and
    (ii) when the compared difference is less than said fixed value, said floating processing is carried out using a common index for said small block within said critical band.

2.  Apparatus according to claim 1 wherein said floating processing is carried out by determining a maximum absolute value of all words of a digital signal within said respective small blocks to use said maximum absolute value as a floating coefficient common to all the words within said small blocks.

3.  Apparatus according to claim 2 wherein when a difference between respective maximum values of said these respective small blocks is more than 6 dB, the floating processing is carried out on each respective small block.

4. Apparatus according to claim 2 wherein said floating processing includes requantization processing.

5. Apparatus according to any one of the preceding claims wherein said orthogonal transform is fast Fourier transform.

6. Apparatus according to any one of claims 1 to 5 wherein said orthogonal transform is discrete cosine transform.

**Patentansprüche**

1. Codiervorrichtung für ein digitales Signal mit

einem Teiler (12, 12) zum Teilen eines digitalen Eingangssignals in Signalkomponenten in mehreren Bändern mit vorbestimmten Frequenzen,
einer orthogonalen Transformationsschaltung (13, 14, 15), die jedes Teilband einer orthogonalen Transformation unterzieht, wobei Signalkomponenten auf der Frequenzbasis in kritische Blöcke unterteilt werden und
einem Gleitprozessor ($47_1$, $47_2$; 18), der eine gleitende Verarbeitung der genannten Blöcke durchführt,

**gekennzeichnet durch**

Mittel zur weiteren Unterteilung der Blöcke der kritischen Bändern in kleine Blöcke und
Mittel ($46_1$, $46_2$, 52; 20) zum Festlegen und Vergleichen entsprechender Indizes für die gleitende Verarbeitung für jeden der kleinen Blöcke und zur Steuerung des Gleitprozessors in der Weise, daß

(i) dann, wenn die Vergleichsdifferenz über einem festen Wert liegt, die gleitende Verarbeitung unter Verwendung unterschiedlicher Indizes für unterschiedliche kleine Blöcke innerhalb eines kritischen Bandes ausgeführt wird, und

(ii) dann, wenn die Vergleichsdifferenz kleiner ist als der feste Wert, die gleitende Verarbeitung unter Verwendung eines gemeinsamen Index für den kleinen Block innerhalb des kritischen Bandes ausgeführt wird.

2. Vorrichtung nach Anspruch 1, bei der die gleitende Verarbeitung ausgeführt wird, indem ein maximaler Absolutwert aller Wörter eines digitalen Signals innerhalb der jeweiligen kleinen Blöcke festgelegt wird und dieser maximale Absolutwert als gemeinsamer Gleitkoeffizient für alle Wörter innerhalb der genannten kleinen Blöcke verwendet wird.

3. Vorrichtung nach Anspruch 2, bei der dann, wenn die Differenz zwischen den jeweiligen Maximalwerten der betreffenden kleinen Blöcke größer ist als 6 dB, die gleitende Verarbeitung an jedem kleinen Block ausgeführt wird.

4. Vorrichtung nach Anspruch 2, bei der die gleitende Verarbeitung eine Neuquantisierung beinhaltet.

5. Vorrichtung nach einem der vorhergehenden Ansprüche, bei der die orthogonale Transformation eine schnelle Fourier-Transformation ist.

6. Vorrichtung nach einem der Ansprüche 1 bis 5, bei der die orthogonale Transformation eine diskrete Cosinus-Transformation ist.

**Revendications**

1. Appareil de codage pour un signal numérique, ledit appareil de codage comprenant :

un diviseur (11, 12) pour diviser un signal numérique d'entrée numérique en composantes de signal dans une pluralité de bandes de fréquences prédéterminées ;
un circuit de transformée orthogonale (13, 14, 15) effectuant une transformée orthogonale sur chaque bande divisée, les composantes de signal sur une base fréquencielle étant divisées en blocs dans des bandes critiques, et ;
un processeur flottant ($47_1$, $47_2$; 18) effectuant un traitement flottant desdits blocs caractérisé par :
des moyens pour diviser, de plus, lesdits blocs desdites bandes critiques en petits blocs ; et
des moyens ($46_1$, $46_2$, 52 ; 20) pour déterminer et comparer des indices respectifs pour le traitement flottant pour chaque petit bloc et pour commander ledit processeur flottant de sorte que :

(i) lorsque la différence comparée est au-dessus d'une valeur fixée, on effectue ledit traitement flottant en utilisant différents indices pour différents petits blocs à l'intérieur d'une bande critique ; et
(ii) lorsque la différence comparée est inférieure à ladite valeur fixée, on effectue ledit traitement flottant en utilisant un indice commun pour ledit petit bloc à l'intérieur de ladite bande critique.

2. Appareil selon la revendication 1, dans lequel on effectue ledit traitement flottant en déterminant une valeur absolue maximale de tous les mots d'un signal numérique à l'intérieur desdits petits blocs respectifs pour utiliser ladite valeur absolue maximale en tant que coefficient flottant commun à tous les mots à l'intérieur desdits petits blocs.

3. Appareil selon la revendication 2, dans lequel, quand une différence entre des valeurs maximales respectives de ces dits petits blocs respectifs est supérieure à 6 dB, on effectue le traitement flottant sur chaque petit bloc respectif.

4. Appareil selon la revendication 2, dans lequel ledit traitement flottant comprend un traitement de requantification.

5. Appareil selon l'une quelconque des revendications précédentes, dans lequel ladite transformée orthogonale est une transformée de Fourier rapide.

6. Appareil selon l'une quelconque des revendications 1 à 5, dans lequel ladite transformée orthogonale est une transformée de cosinus discret.

FIG.1

**FIG.2**

**FIG.3**

**FIG. 4**

**FIG.5**

EP 0 507 499 B1

**FIG.6**

FIG.7

FIG.8

EP 0 507 499 B1

FIG. 9

**FIG.10**

**FIG.11**

**FIG.12**